# EUROPEAN PATENT SPECIFICATION

(11) **EP 2 731 385 B1**
(45) Date of publication and mention of the grant of the patent: **04.07.2018**
(21) Application number: 14153801.7
(22) Date of filing: 11.08.2011
(51) Int. Cl.: H04W 52/02, G01R 19/165

(54) **Control processing method of energy-saving cell and base station**
STEUERUNGSVERARBEITUNGSVERFAHREN FÜR EINE STROMSPARENDE ZELLE UND BASISSTATION
PROCÉDÉ DE TRAITEMENT DE COMMANDE DE CELLULE À ÉCONOMIES D'ÉNERGIE ET STATION DE BASE

(30) Priority: 11.08.2010 CN 201010251143
(43) Date of publication of application: 14.05.2014
(62) Divisional of application: 11816105.8
(73) Proprietor: China Academy of Telecommunications Technology, Haidian District, Beijing 100191 (CN)
(72) Inventor: Zhang, Dajun, 100191 Beijing (CN); Chen, Li, 100191 Beijing (CN)
(74) Representative: Lavoix

(56) References cited:
- EP-A1- 2 056 628
- EP-A1- 2 141 947
- MITSUBISHI ELECTRIC: "Dynamic Setup of HNBs for Energy Savings and Interference Reduction", 3GPP DRAFT; R3-081949 (DYNAMIC SETUP HNBS), 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. RAN WG3, no. Jeju Island; 20080813, 13 August 2008 (2008-08-13), XP050165010, [retrieved on 2008-08-13]

## Description

This application claims the benefit of Chinese Patent Application No. 201010251143.1, filed with the Chinese Patent Office on August 11, 2010 and entitled "Method for control process of energy-saving cell and base station".

### Field

The present invention relates to the field of wireless communications and particularly to a method for a control process of an energy-saving cell and a base station.

### Background

At present the following approaches are available for energy saving of a mobile communication network.
1. The number of site addresses is optimized without influencing any coverage, capacity and quality of service.
2. An effective solution is sought to an improved utilization ratio of energy sources and lowered power consumption of devices.
3. Sustainable energy resources (e.g., wind energy, solar energy, etc.) are researched and developed.

Devices at the Radio Access Network (RAN) side are intended primarily for a demand during high-traffic hours, and for a cell with three sectors, there are 4 transceivers in each sector, and thus there are 12 transceivers stay in an active state all the time although this may not be necessary. If an energy source control mechanism is introduced, then a traffic demand can be satisfied so long as there is only one transceiver kept in a standby state in each sector during low-traffic hours (e.g., a midnight). If this energy-saving strategy is applicable to all evolved Nodes B (eNBs), then a considerable energy source can be saved without influencing any quality of service.

For a self-optimized network, energy-saving entities therein may constitute any one of the following three architectures:
1. A distributed architecture where a network element collects necessary information for a self-optimization process without involving any Operation and Maintenance (OAM).
2. A centralized architecture where OAM collects information from a network element for triggering an energy-saving algorithm and then decides a subsequent action of the network element.
3. A hybrid architecture where both of the foregoing architectures are used in combination.

An Energy Saving Management (ESM) solution: the concept of ESM refers to optimization of a utilization ratio at which resources of the entire network or a part thereof are utilized. ESM collects and evaluates relevant information from the network and initiates an appropriate action to adjust the configuration of the network to thereby satisfy a service demand.

The energy-saving solution includes two general procedures:
1. Energy-saving activation: a cell of an eNB is disabled or the use of a part of devices and resources thereof is limited for the purpose of energy saving, and the corresponding eNB is brought into an energy-saving state.
2. Energy-saving deactivation: a disabled cell is enabled or the use of devices and resources thereof is resumed to satisfy an increased traffic demand and Quality of Service (QoS) demand, and the corresponding eNB is brought from an energy-saving state back into a normal state.

Energy-saving actions include:
# Disabling/enabling of a cell;
# Disabling/enabling of a carrier;
# Disabling/enabling of a transceiver;
# Disabling/enabling of an eNB; and
# Others.

Energy-saving compensation: when a network element is brought into an ESM state, a nearby network element in normal operation will be brought into an energy-saving compensation state to compensate an energy-saving traffic loss of an ESM cell through extending a coverage area or otherwise.

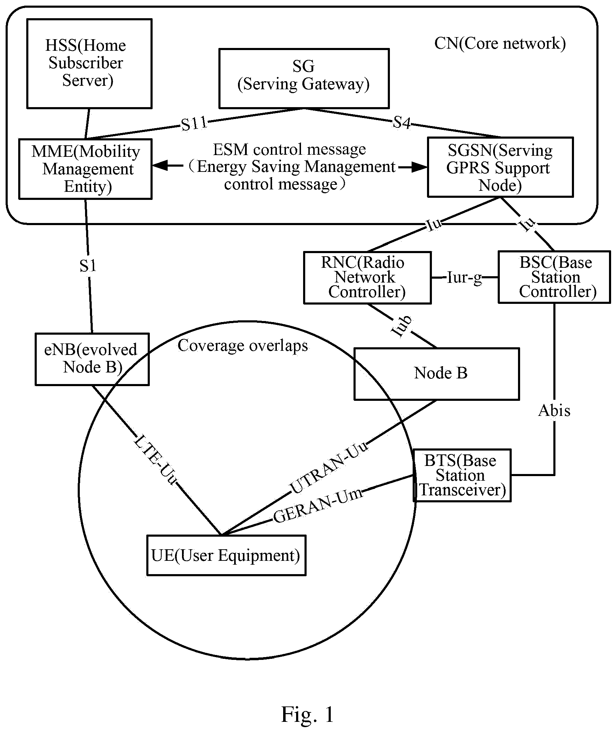

Fig.1 is a schematic structural diagram of a network of heterogeneous systems, and as illustrated, the structure of the network of heterogeneous systems generally includes S1, Iub, Iu, Abis, Iur-g and other interfaces.

In an energy-saving solution and flow in an existing Long Term Evolution (LTE) system, an essential coverage cell decides to activate an energy-saving cell under the coverage cell according to a load condition of the coverage cell, and the corresponding energy-saving cell can disable a transmitter by itself into an energy-saving state in the case of a very low load.

A drawback of the prior art lies in that all energy-saving cells under a coverage cell have to be activated when a energy-saving cell is required to be activated in the energy-saving solution and flow in the existing LTE system, thus inevitably resulting in an unnecessary waste of energy.

EP2056628A1(NOKIA SIEMENS NETWORKS OY[FI]) discloses "a communication network element for a communication network having cells is provided, the communication network element comprising a generation unit adapted to generate a switching signal based on a communication load in a cell of the communication network, wherein the switching signal is adapted to switch an activity state".

### Summary

An aspect of the invention is to provide a method for a control process of an energy-saving cell and a base station so as to address the problem in the prior art of the impossibility to control effectively an energy-saving cell in the LTE.

There is provided in an embodiment of the invention a method for a control process of an energy-saving cell, which includes the operations of:
a base station serving an essential coverage cell determining whether a current load state of the essential coverage cell is above or equal to a preset energy-saving threshold, where an additional cell or cells are required to participate in a service when the current load state is above or equal to the preset energy-saving threshold, and the essential coverage cell refers to a cell that can not be disabled or brought into an energy-saving state in view of guaranteed continuity;
the base station serving the essential coverage cell determining a distribution state of current service loads of currently serving cells when the current load state is above or equal to the preset energy-saving threshold;
the base station serving the essential coverage cell determining an energy-saving cell to be activated according to energy-saving cell information and the distribution state of the current service loads, where the energy-saving cell is a cell that can be brought into the energy-saving state; and
the base station serving the essential coverage cell activating the determined energy-saving cell.

There is provided in an embodiment of the invention a method for a control process of an energy-saving cell, which includes the operations of:
a base station serving an essential coverage cell determining required activation of an energy-saving cell according to a current load state, where the essential coverage cell refers to a cell that can not be disabled or brought into an energy-saving state in view of guaranteed continuity, and the energy-saving cell refers to a cell that can be brought into the energy-saving state;
the base station serving the essential coverage cell instructing energy-saving cells to be brought into a limited transmission state, wherein the limited transmission state refers to transmission of only limited downlink signals without any access operation;
the base station serving the essential coverage cell instructing a user equipment to measure a signal or signals of a local cell and/or an adjacent cell or cells;
the base station serving the essential coverage cell determining an energy-saving cell to be activated, wherein the base station serving the essential coverage cell determines an energy-saving cell to be activated according to a local energy-saving strategy and a service demand of the UE; and
the base station serving the essential coverage cell activating the determined energy-saving cell.

There is provided in an embodiment of the invention a base station including:
a determination module configured to determine whether a current load state of the base station serving an essential coverage cell is above or equal to a preset energy-saving threshold, where an additional cell or cells are required to participate in a service when the current load state is above or equal to the preset energy-saving threshold, and the essential coverage cell refers to a cell that can not be disabled or brought into an energy-saving state in view of guaranteed continuity;
a load distribution module configured to determine a distribution state of current service loads of currently serving cells when the current load state is above or equal to the preset energy-saving threshold;
an energy-saving cell determination module configured to determine an energy-saving cell to be activated according to energy-saving cell information and the distribution state of the current service loads, where the energy-saving cell is a cell that can be brought into the energy-saving state; and
an activation module configured to activate the determined energy-saving cell.

There is provided in an embodiment of the invention a base station including:
a determination module configured to determine required activation of an energy-saving cell according to a current load state of the base station serving an essential coverage cell, where the essential coverage cell refers to a cell that can not be disabled or brought into an energy-saving state in view of guaranteed continuity, and the energy-saving cell refers to a cell that can be brought into the energy-saving state;
an instruction module configured to instruct energy-saving cells to be brought into a limited transmission state, wherein the instruction module is further configured to instruct the energy-saving cells to be brought into the limited transmission state in which only limited downlink signals are transmitted in the energy-saving cells without any access operation;
an instructing module configured to instruct a user equipment to measure a signal or signals of a local cell and/or an adjacent cell or cells;
an energy-saving cell determination module configured to determine an energy-saving cell to be activated, wherein the energy-saving cell determination module is further configured to determine an energy-saving cell to be activated according to a local energy-saving strategy of the base station serving the essential coverage cell and a service demand of the UE; and
an activation module configured to activate the determined energy-saving cell.

Advantageous effects of the invention are as follows:
The solutions to selective activation and deactivation of an energy-saving cell across heterogeneous systems are provided to thereby overcome the problem in an LTE system of an energy waste due to only full activation being possible, thus optimizing an existing energy-saving technology and further improving an energy utilization ratio throughout a network.

### Brief Description of the Drawings

Fig. 1 is a schematic structural diagram of a network of heterogeneous systems in the prior art;
Fig. 2 is a schematic flow chart of performing a method for a control process of activating an energy-saving cell in an embodiment of the invention;
Fig. 3 is a schematic diagram of obtaining energy-saving cell information from OAM in an embodiment of the invention;
Fig. 4 is a schematic flow chart of performing a method for a control process of an energy-saving cell in a first embodiment of the invention;
Fig. 5 is a schematic flow chart of performing a method for a control process of activating an energy-saving cell in an embodiment of the invention;
Fig. 6 is a schematic flow chart of performing a method for a control process of an energy-saving cell in a fourth embodiment of the invention;
Fig. 7 is a schematic structural diagram of a first base station in an embodiment of the invention; and
Fig. 8 is a schematic structural diagram of a second base station in an embodiment of the invention.

### Detailed Description of the Embodiments

A technical solution according to an embodiment of the invention generally lies in that a cell or node providing an essential coverage in a hierarchical network architecture is configured to activate selectively an energy-saving cell according to a distribution condition of a network load in combination with associated energy-saving cell information, e.g., cell coverage areas, cell types or capacities, etc. Embodiments of the invention will be specifically described below with reference to the drawings.

General concepts as referred to in this application will be described at first.

An energy-saving cell refers to a cell that can be brought into an energy-saving state, where the so-called energy-saving state refers to a radio frequency-disabled state.

A serving cell refers to a cell currently serving a user equipment.

A capacity extension cell refers to another radio access layer (cell) provided in addition to an essential coverage layer to increase the capacity of the entire system.

An essential coverage cell providing an essential coverage refers to that such a cell can not be disabled or brought into an energy-saving state in view of guaranteed continuity.

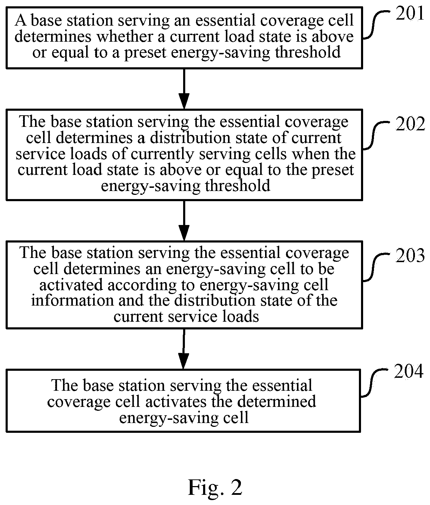

Fig.2 is a schematic flow chart of performing a method for a control process of activating an energy-saving cell, and as illustrated, activation of an energy-saving cell may include the following operations:
Operation 201. A base station serving an essential coverage cell determines whether a current load state of the essential coverage cell is above or equal to a preset energy-saving threshold, where an additional cell or cells are required to participate in a service when the current load state is above or equal to the preset energy-saving threshold, and the essential coverage cell refers to a cell that can not be disabled or brought into an energy-saving state in view of guaranteed continuity;
Operation 202. The base station serving the essential coverage cell determines a distribution state of current service loads of currently serving cells when the current load state is above or equal to the preset energy-saving threshold;
Operation 203. The base station serving the essential coverage cell determines an energy-saving cell to be activated according to energy-saving cell information and the distribution state of the current service loads, where the energy-saving cell is a cell that can be brought into an energy-saving state; and
Operation 204. The base station serving the essential coverage cell activates the determined energy-saving cell.

In an implementation, after the base station serving the essential coverage cell activates the energy-saving cell, the process may further include:
The base station serving the essential coverage cell determines whether a current load state is above or equal to the preset energy-saving threshold;
The base station serving the essential coverage cell determines a distribution state of current service loads of currently serving cells when the current load state is above or equal to the preset energy-saving threshold;
The base station serving the essential coverage cell determines an energy-saving cell to be activated according to energy-saving cell information and the distribution state of the current service loads;
The base station serving the essential coverage cell activates the determined energy-saving cell; and
The foregoing operations are repeated until the current load state is below the preset energy-saving threshold.

In an implementation, the energy-saving cell information may be obtained from OAM.

In the operation 203, the energy-saving cell to be activated determined by the base station serving the essential coverage cell according to the energy-saving cell information and the distribution state of the current service loads may be an energy-saving cell in a coverage area after activation, determined by the base station serving the essential coverage cell, in which the number of UEs is above a preset number, or an energy-saving cell, determined by the base station of the essential coverage cell, which can provide current user equipments with an amount of traffic above a preset number of bytes after activation. Of course, those skilled in the art can devise other specific approaches to select an energy-saving cell to be activated dependent upon a practical condition.

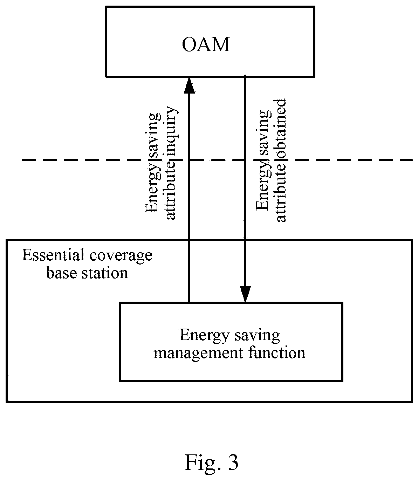

Fig.3 is a schematic diagram of obtaining energy-saving cell information from OAM, and as illustrated, a function entity, a device, etc., with an energy-saving management function is provided on an essential coverage base station to transmit an energy-saving cell information obtainment message to OAM to thereby obtain energy-saving cell information from the OAM. For example, an inquiry about an energy-saving attribute is made as illustrated.

In an implementation, the energy-saving cell information may be obtained via an S1 and/or X2 interface.
1. Energy-saving cell attribute information may be transferred to each base station providing an essential coverage through the OAM in an inter-RAT (RAT stands for Radio Access Technology) scenario.

Energy-saving cell attribute information may be obtained via an S1 interface in the following specific format of information elements:

SON Transfer Application Identity (SON stands for Self Organizing Networks)

| IE/Group Name | Range of values | Comment |
|---|---|---|
| SON Transfer Application Identity | ENUMERATED (Cell Load Reporting, ..., **Energy Saving**) | Indicate required transfer of energy-saving related information |

SON Transfer Request Container

| IE/Group Name | Range of values | Comment |
|---|---|---|
| CHOICE SON Transfer Application | | |
| >Cell Load Reporting | NULL | |
| **>Energy Saving** | | **Request destination cell for transferring energy-saving information** |

SON Transfer Response Container

| IE/Group Name | Range of values | Comment |
|---|---|---|
| CHOICE SON Transfer Application | | |
| >Cell Load Reporting | | |
| >>Response | Cell Load Reporting Response B.1.5 | |
| **>Energy Saving** | | |
| **>>Response** | | Energy-saving related information |

Energy-saving related information

| IE/Group Name | Range of values | Comment |
|---|---|---|
| **Service Coverage Area** | | **Service coverage area** |
| **Cell Capacity** | | **Indicate cell capacity, e.g., bandwidth, central frequency point, etc.** |

A service coverage area may define a circle:

| IE/Group Name | Range of values | Comment |
|---|---|---|
| Geographical coordinates | | Identify coordinates of central point |
| Radius | | Identfy radius of center |

Or a geometrical graph, etc.

| IE/Group Name | Range of values | Comment |
|---|---|---|
| Geometrical graph | *1.. <maxnoofPoints>* | |
| > Geographical coordinates | | Identify coordinates of a point |

It is preconfigured according to network planning or obtained through a driver test.
2. Energy-saving cell attribute information may be transferred to each base station providing an essential coverage through the OAM in an inter-eNB scenario.

Energy-saving cell attribute information may be obtained via an X2 interface in the following specific format of information elements:

| IE/Group Name | Range of values | Comment |
|---|---|---|
| PCI | | Physical Cell ID |
| Cell ID | | |
| TAC | | Tracking Area Code |
| Broadcast PLMNs | *1..<maxnoofBPLMNs>* | Broadcast PLMNs |
| >PLMN Identity | | |
| ... | | |
| Number of Antenna Ports | | |
| PRACH Configuration | | |
| MBSFN Subframe Info | *0 to maxnoofMBSFN* | MBSFN subframe configuration information defined in ref. [9] |
| >Radioframe Allocation Period | | |
| >Radioframe Allocation Offset | | |
| >Subframe Allocation | | |
| **Service Coverage Area** | | **Service coverage area** |

In an implementation, the energy-saving cell information may include any one or combination of cell coverage areas, cell types, cell capacities, etc.

In an implementation, the base station serving the essential coverage cell may determine the distribution state of the current traffic loads of the current serving cells in any one or combination of the following approaches:
1. Measurement values of preamble signals of a local cell where a UE resides and an adjacent cell or cells are obtained in a periodical or event-triggered UE measurement report procedure initiated by a serving cell, and location information of the UE is obtained from comparison of the measurement values with a pre-configured preamble distribution mapping table.
   Specifically the serving cell initiates the periodical or event-triggered UE measurement report procedure and thus obtains the measurement values of the preamble signals of the local cell where a UE resides and the an adjacent cell or cells and further compares them with the pre-configured preamble distribution mapping table to thereby obtain the rough location information of the UE.
2. Location information of a UE is obtained in periodical or event-triggered Angle of Arrival (AOA) and Timing Advance measurement procedures initiated by a serving cell for the UE.
   Specifically the serving cell initiates for the UE the periodical or event-triggered AOA and Timing Advance measurement procedures and may estimate roughly from these two pieces of information the information on the location where the UE currently resides.
3. Location information of a UE is obtained in a periodical UE location information report procedure triggered by a serving cell.
   Specifically the serving cell initiates the periodical UE location information report procedure in which the report procedure may be performed on a core network, for example, the eNB transmits a Location Report Request message to an MME, and the MME returns a Location Report message.
4. Location information of a UE is obtained in a triggered location information report procedure of the UE.

Specifically the location information report procedure of the UE may be triggered, where the procedure is performed in a Radio Resource Control (RRC) message.

A description will be given below in connection with embodiments.

### First Embodiment

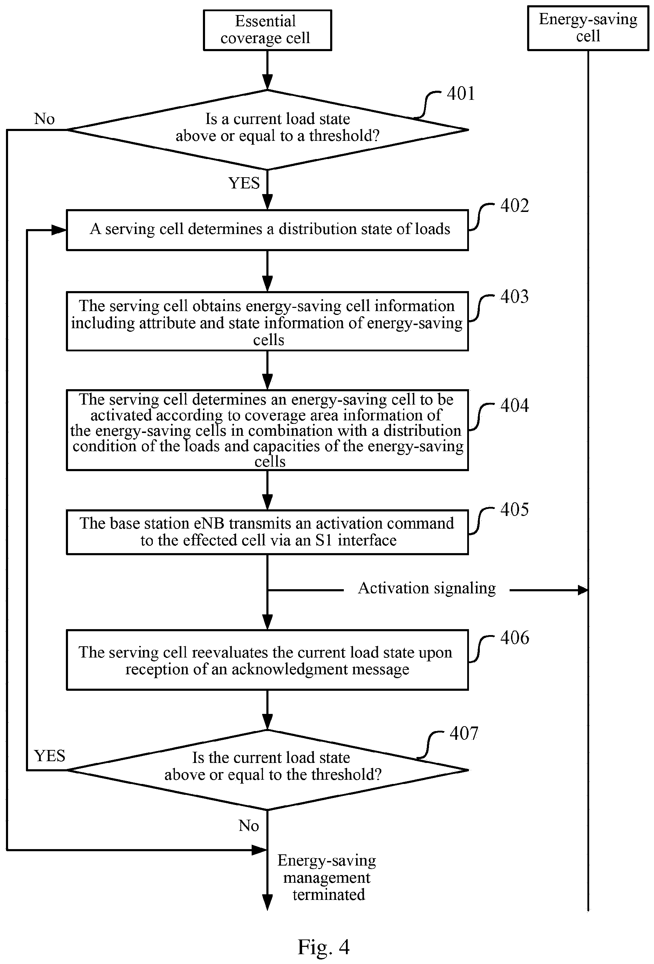

Fig.4 is a schematic flow chart of performing a method for a control process of an energy-saving cell in a first embodiment of the invention, and as illustrated, activation of an energy-saving cell may include the following operations:
Operation 401. A base station of an essential coverage cell determines whether a current load state is above or equal to a threshold, and if so, then the process goes to the operation 402; otherwise, activation of an energy-saving cell is terminated;
Operation 402. A serving cell determines a distribution state of loads;
Operation 403. The serving cell obtains energy-saving cell information including attribute and state information of energy-saving cells;
Operation 404. The serving cell determines an energy-saving cell to be activated according to coverage area information of the energy-saving cells in combination with a distribution condition of the loads and capacities of the energy-saving cells (bandwidths, frequency points and other information obtained via an S1 interface);
Operation 405. The base station (eNB) transmits an activation command to the effected cell via an S1 interface;
Operation 406. The serving cell reevaluates the current load state upon reception of an acknowledgment message; and
Operation 407. It is determined whether the current load state is above or equal to the threshold, and if the essential coverage load state is below the threshold, then energy-saving management is terminated; otherwise, the process goes to the operation 402 and repeats the foregoing operations until a preset number of repetitions is reached or until the current load state is below the preset energy-saving threshold.

### Second Embodiment

In this embodiment, a selective energy-saving cell activation process initiated by an essential coverage cell will be described from the perspectives of implementations thereof at respective apparatus in an inter-RAT scenario.

A base station apparatus providing an essential coverage cell generally performs the following functions:
1. To obtain energy-saving cell information upon determining that a load reaches a threshold;
2. To determine a distribution condition of loads; and
3. To activate an energy-saving cell via an S1 interface.

An OAM apparatus generally performs the following functions:
1. To configure and provide the energy-saving cell information to the base station apparatus serving the essential coverage cell; and
2. To configure and provide an energy-saving strategy, the load threshold, etc. to the base station apparatus serving the essential coverage cell.

A base station apparatus providing an energy-saving cell generally performs the following functions:
1. To receive an activation message from the base station apparatus serving the essential coverage cell via the S1 interface and to perform an activation operation; and
2. To receive cell coverage inquiry information from the base station apparatus serving the essential coverage cell via the S1 interface and to feed back corresponding information.

### Third Embodiment

In this embodiment, a selective energy-saving cell activation process initiated by an essential coverage cell will be described from the perspectives of implementations thereof at respective apparatuses in an inter-base station scenario.

A base station apparatus providing an essential coverage cell generally performs the following functions:
1. To obtain energy-saving cell information upon determining that a load state reaches a threshold;
2. To determine a distribution condition of loads; and
3. To activate an energy-saving cell via an X2 interface.

An OAM apparatus generally performs the following functions:
1. To configure and provide energy-saving cell attribute information to the base station apparatus serving the essential coverage cell; and
2. To configure and provide an energy-saving strategy, the load threshold, etc. to the base station apparatus serving the essential coverage cell.

A base station apparatus providing an energy-saving cell generally performs the following functions:
1. To receive an activation message from the base station apparatus serving the essential coverage cell via the X2 interface and to perform an activation operation; and
2. To receive cell coverage inquiry information from the base station apparatus serving the essential coverage cell via the X2 interface and to feed back corresponding information.

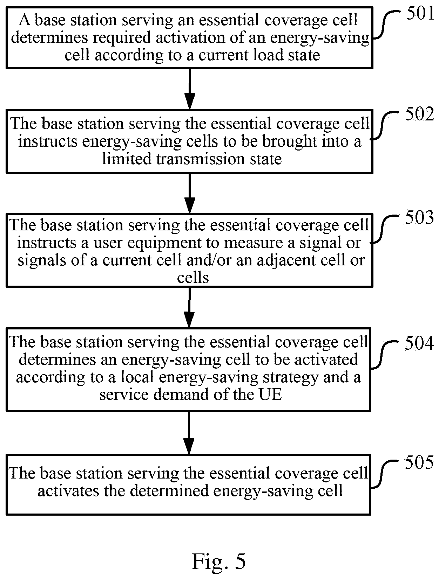

Fig.5 is a schematic flow chart of performing a method for a control process of activating an energy-saving cell, and as illustrated, activation of an energy-saving cell may include the following operations:
Operation 501. A base station serving an essential coverage cell determines required activation of an energy-saving cell according to a current load state, where the essential coverage cell refers to a cell that can not be disabled or brought into an energy-saving state in view of guaranteed continuity, and the energy-saving cell refers to a cell that can be brought into an energy-saving state;
Operation 502. The base station serving the essential coverage cell instructs energy-saving cells to be brought into a limited transmission state;
Operation 503. The base station serving the essential coverage cell instructs a user equipment to measure a signal or signals of a local cell and/or an adjacent cell or cells;
Operation 504. The base station serving the essential coverage cell determines an energy-saving cell to be activated according to a local energy-saving strategy and a service demand of the UE; and
Operation 505. The base station serving the essential coverage cell activates the determined energy-saving cell.

In an implementation, the base station serving the essential coverage cell may instruct the energy-saving cells to be brought into the limited transmission state via an S1 and/or X2 interface.

Specifically a relevant cell or cells may be signaled via an S1/X2 interface in the following format of information elements:

| IE/Group Name | Range of values | Comment |
|---|---|---|
| CHOICE Energy saving Application | | |
| **>Limited Transmission Cell List** | | **List of transmission limited cells** |
| **>>ECGI** | | **Identify cell uniquely** |

In an implementation, the limited transmission state may refer to transmission of only limited downlink signals without any access operation.

Specifically the limited transmission state of the energy-saving cell may be a state in which only limited downlink signals, e.g., a preamble, a synchronization signal, etc., are transmitted at the lowest energy without any access or other radio operations.

In an implementation, the base station serving the essential coverage cell may activate the determined energy-saving cell via an S1 and/or X2 interface.

A description will be given below in connection embodiments

### Fourth Embodiment

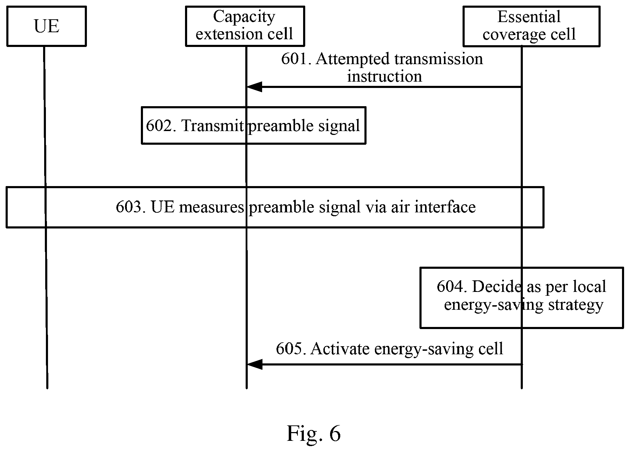

Fig.6 is a schematic flow chart of performing a method for a control process of an energy-saving cell in a fourth embodiment of the invention, and as illustrated, activation of an energy-saving cell may include the following operations:
Operation 601. An essential coverage cell transmits an attempted transmission instruction to all relevant energy-saving cells when the essential coverage cell decides required activation of some energy-saving cells according to a current load state;
Operation 602. The energy-saving cells are brought into a limited transmission state in which only limited downlink signals are transmitted without perform any access or other operations;
Operation 603. The essential coverage cell instructs a relevant user equipment to measure a signal or signals of a local cell/an adjacent cell or cells;
Operation 604. The essential coverage cell decides some energy-saving cells to be activated according to a local energy-saving strategy in combination with a service demand of the UE and other information; and
Operation 605. The essential coverage cell transmits a message of deactivating an energy-saving state to the some energy-saving cells.

### Fifth Embodiment

In this embodiment, a selective energy-saving cell activation process performed by an essential coverage cell in an attempted transmission instruction procedure will be described from the perspective of implementations at respective apparatuses.

A base station apparatus providing an essential coverage cell generally performs the following functions:
1. To instruct an adjacent cell or cells to be brought into a limited transmission state;
2. To trigger a UE to report a measurement or measurements; and
3. To activate an energy-saving cell via an S1 interface.

A base station apparatus providing an energy-saving cell generally performs the following functions:
1. To receive an attempted transmission instruction message from the base station apparatus serving the essential coverage cell via the S1/X2 interface and to be brought into a limited transmission state; and
2. To receive an activation message from the base station apparatus serving the essential coverage cell via the S1/X2 interface and to perform an activation operation.

Based upon the same inventive idea, there is further provided in an embodiment of the invention a base station, and since the base station apparatus addresses the problem under a similar principle to the method for a control process of an energy-saving cell, reference can be made to the implementation of the method for an implementation of the base station apparatus, and a repeated description thereof will be omitted here.

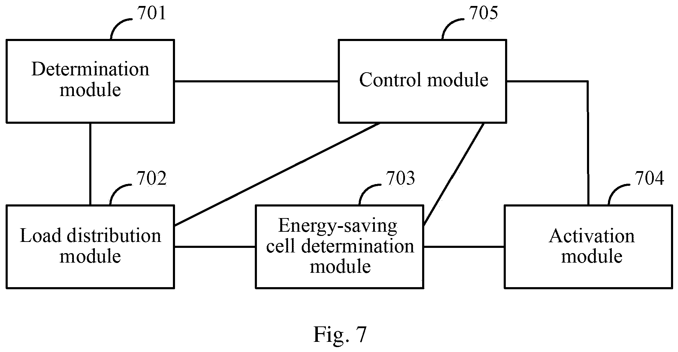

Fig.7 is a schematic structural diagram of a first base station, and as illustrated, the base station may include:
a determination module 701 configured to determine whether a current load state of the base station serving an essential coverage cell is above or equal to a preset energy-saving threshold, where an additional cell or cells are required to participate in a service when the current load state is above or equal to the preset energy-saving threshold, and the essential coverage cell refers to a cell that can not be disabled or brought into an energy-saving state in view of guaranteed continuity;
a load distribution module 702 configured to determine a distribution state of current service loads of currently serving cells when the current load state is above or equal to the preset energy-saving threshold;
an energy-saving cell determination module 703 configured to determine an energy-saving cell to be activated according to energy-saving cell information and the distribution state of the current service loads, where the energy-saving cell is a cell that can be brought into an energy-saving state; and
an activation module 704 configured to activate the determined energy-saving cell.

In an implementation, the base station may further include:
a control module 705 configured to trigger the determination module, the load distribution module, the energy-saving cell determination module and the activation module to operate repeatedly until the current load state is below the preset energy-saving threshold.

In an implementation, the energy-saving cell determination module may further be configured to obtain the energy-saving cell information from OAM.

In an implementation, the energy-saving cell determination module may further be configured to obtain the energy-saving cell information via an S1 and/or X2 interface.

In an implementation, the energy-saving cell determination module may further be configured to obtain the energy-saving cell information including any or combination of cell coverage areas, cell types and cell capacities.

In an implementation, the load distribution module may include any one or combination of:
a first location unit configured to obtain measurement values of preamble signals of a local cell where a UE resides and an adjacent cell or cells in a periodical or event-triggered UE measurement report procedure initiated by a serving cell and to obtain location information of the UE from comparison of the measurement values with a pre-configured preamble distribution mapping table;
a second location unit configured to obtain location information of a UE in periodical or event-triggered AOA and Timing Advance measurement procedures initiated by a serving cell for the UE;
a third location unit configured to obtain location information of a UE in a periodical UE location information report procedure triggered by a serving cell; and
a fourth location unit configured to obtain location information of a UE in a triggered location information report procedure of the UE.

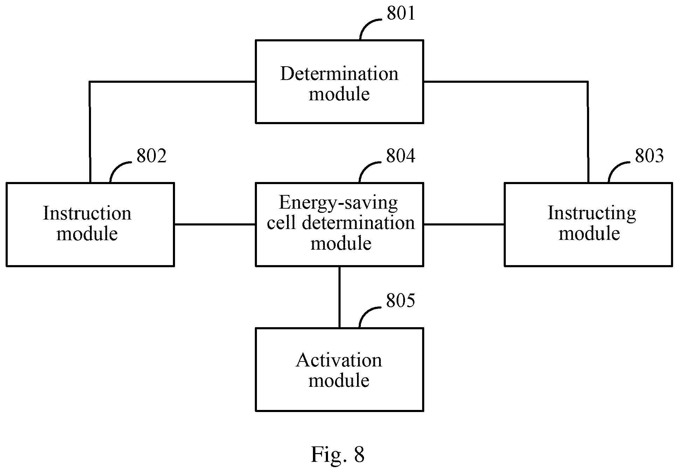

Fig.8 is a schematic structural diagram of a second base station, and as illustrated, the base station may include:
a determination module 801 configured to determine required activation of an energy-saving cell according to a current load state of the base station serving an essential coverage cell, where the essential coverage cell refers to a cell that can not be disabled or brought into an energy-saving state in view of guaranteed continuity, and the energy-saving cell refers to a cell that can be brought into the energy-saving state;
an instruction module 802 configured to instruct energy-saving cells to be brought into a limited transmission state;
an instructing module 803 configured to instruct a user equipment to measure a signal or signals of a local cell and/or an adjacent cell or cells;
an energy-saving cell determination module 804 configured to determine an energy-saving cell to be activated according to a local energy-saving strategy of the base station serving the essential coverage cell and a service demand of the UE; and
an activation module 805 configured to activate the determined energy-saving cell.

In an implementation, the instruction module may further be configured to instruct the energy-saving cells to be brought into the limited transmission state via an S1 and/or X2 interface.

In an implementation, the activation module may further be configured to activate the determined energy-saving cell via an S1 and/or X2 interface.

In an implementation, the instruction module may further be configured to instruct the energy-saving cells to be brought into the limited transmission state in which only limited downlink signals are transmitted in the energy-saving cells without any access operation.

For the convenience of a description, the respective components of the foregoing apparatuses have been described respectively by functionally dividing them into respective modules or units. Of course the functions of the respective modules or units can be performed in the same one or a plurality of items of software or hardware to put the invention into practice.

As can be apparent from above, in the technical solution according to the embodiments of the invention, a cell or node providing an essential coverage in a hierarchical network architecture is configured to activate selectively an energy-saving cell according to a distribution condition of a network load in combination with associated energy-saving cell information, e.g., cell coverage areas, cell types or capacities, etc.

Specifically, energy-saving cell attribute information may be transferred to each base station providing an essential coverage through OAM.

Specifically, energy-saving cell attribute information including service coverage areas, cell capacities, etc., may be obtained via an S1/X2 interface.

Specifically, rough location information of a UE may be obtained by comparing measurement values of preamble signals of a local cell where the UE resides and an adjacent cell or cells with a preconfigured preamble distribution mapping table. Alternatively a serving cell initiates periodical or event-triggered Angle of Arrival (AOA) and Timing Advance measurement procedures for a UE, and information on the location where the UE currently resides may be estimated roughly from these two pieces of information. Alternatively a serving cell triggers a periodical UE location information report procedure in which the report procedure may be performed on a core network.

Specifically an attempted transmission instruction may be transmitted to a relevant cell or cells via an S1/X2 interface.

Specifically the limited transmission state of an energy-saving cell may be defined as a state in which only limited downlink preamble signals are transmitted at the lowest energy without any access or other radio operations.

Specifically a coverage cell decides some energy-saving cells to be activated according to a local energy-saving strategy in combination with a preamble measurement or measurements of a UE, a service demand of the UE and other information.

As can be apparent, there are provided in the embodiments of the invention the solutions to selective activation and deactivation of an energy-saving cell across heterogeneous systems to thereby optimize the existing energy-saving technology and to further improve an energy utilization ratio throughout a network.

Those skilled in the art shall appreciate that the embodiments of the invention can be embodied as a method, a system or a computer program product. Therefore the invention can be embodied in the form of an all-hardware embodiment, an all-software embodiment or an embodiment of software and hardware in combination. Furthermore the invention can be embodied in the form of a computer program product embodied in one or more computer useable storage mediums (including but not limited to a disk memory, a CD-ROM, an optical memory, etc.) in which computer useable program codes are contained.

The invention has been described in a flow chart and/or a block diagram of the method, the device (system) and the computer program product according to the embodiments of the invention. It shall be appreciated that respective flows and/or blocks in the flow chart and/or the block diagram and combinations of the flows and/or the blocks in the flow chart and/or the block diagram can be embodied in computer program instructions. These computer program instructions can be loaded onto a general-purpose computer, a specific-purpose computer, an embedded processor or a processor of another programmable data processing device to produce a machine so that the instructions executed on the computer or the processor of the other programmable data processing device create means for performing the functions specified in the flow(s) of the flow chart and/or the block(s) of the block diagram.

These computer program instructions can also be stored into a computer readable memory capable of directing the computer or the other programmable data processing device to operate in a specific manner so that the instructions stored in the computer readable memory create an article of manufacture including instruction means which perform the functions specified in the flow(s) of the flow chart and/or the block(s) of the block diagram.

These computer program instructions can also be loaded onto the computer or the other programmable data processing device so that a series of operational steps are performed on the computer or the other programmable data processing device to create a computer implemented process so that the instructions executed on the computer or the other programmable device provide steps for performing the functions specified in the flow(s) of the flow chart and/or the block(s) of the block diagram.

Although the preferred embodiments of the invention have been described, those skilled in the art benefiting from the underlying inventive concept can make additional modifications and variations to these embodiments. Therefore the appended claims are intended to be construed as encompassing the preferred embodiments and all the modifications and variations coming into the scope of the invention.

Evidently those skilled in the art can make various modifications and variations to the invention without departing from the scope of the invention. Thus the invention is also intended to encompass these modifications and variations thereto so long as the modifications and variations come into the scope of the claims appended to the invention and their equivalents.

## Claims

1. A method for a control process of an energy-saving cell, comprising:
a base station serving an essential coverage cell determining required activation of an energy-saving cell according to a current load state, wherein the essential coverage cell refers to a cell that can not be disabled or brought into an energy-saving state in view of guaranteed continuity, and the energy-saving cell refers to a cell that can be brought into the energy-saving state;
**characterized in that**, the base station serving the essential coverage cell instructing energy-saving cells to be brought into a limited transmission state, wherein the limited transmission state refers to transmission of only limited downlink signals without any access operation;
the base station serving the essential coverage cell instructing a user equipment to measure a signal or signals of a local cell and/or an adjacent cell or cells;
the base station serving the essential coverage cell determining an energy-saving cell to be activated, wherein the base station serving the essential coverage cell determines an energy-saving cell to be activated according to a local energy-saving strategy and a service demand of the UE; and
the base station serving the essential coverage cell activating the determined energy-saving cell.

2. The method of claim 1, wherein the base station serving the essential coverage cell instructs the energy-saving cells to be brought into the limited transmission state via an S1 and/or X2 interface; and/or
the base station serving the essential coverage cell activates the determined energy-saving cell via an S1 and/or X2 interface.

3. A base station, comprising:
a determining module (801) configured to determine required activation of an energy-saving cell according to a current load state of the base station serving an essential coverage cell, wherein the essential coverage cell refers to a cell that can not be disabled or brought into an energy-saving state in view of guaranteed continuity, and the energy-saving cell refers to a cell that can be brought into the energy-saving state;
**characterized in that**, an instruction module (802) configured to instruct energy-saving cells to be brought into a limited transmission state, wherein the instruction module (802) is further configured to instruct the energy-saving cells to be brought into the limited transmission state in which only limited downlink signals are transmitted in the energy-saving cells without any access operation;
an instructing module (803) configured to instruct a user equipment to measure a signal or signals of a local cell and/or an adjacent cell or cells;
an energy-saving cell determination module (804) configured to determine an energy-saving cell to be activated, wherein the energy-saving cell determination module (804) is further configured to determine an energy-saving cell to be activated according to a local energy-saving strategy of the base station serving the essential coverage cell and a service demand of the UE; and
an activation module configured (805) to activate the determined energy-saving cell.

4. The base station of claim 3, wherein the instruction module (802) is further configured to instruct the energy-saving cells to be brought into the limited transmission state via an S1 and/or X2 interface; and/or
the activation module (805) is further configured to activate the determined energy-saving cell via an S1 and/or X2 interface.

## Patentansprüche

1. Verfahren für einen Steuerungsprozess einer energiesparenden Zelle, umfassend:
dass eine Basisstation, die eine Grundabdeckungszelle versorgt, eine erforderliche Aktivierung einer energiesparenden Zelle gemäß einem aktuellen Lastzustand bestimmt, wobei die Grundabdeckungszelle eine Zelle bezeichnet, die mit Blick auf garantierte Kontinuität nicht deaktiviert oder in einen energiesparenden Zustand versetzt werden kann, und die energiesparende Zelle eine Zelle bezeichnet, die in den energiesparenden Zustand versetzt werden kann,
**dadurch gekennzeichnet, dass** die Basisstation, die die Grundabdeckungszelle versorgt, energiesparende Zellen anweist, in einen Zustand mit eingeschränkter Übertragung versetzt zu werden, wobei der Zustand mit eingeschränkter Übertragung eine Übertragung nur eingeschränkter Abwärtsstreckensignale ohne Zugriffsbetrieb bezeichnet,
dass die Basisstation, die die Grundabdeckungszelle versorgt, ein Benutzerendgerät anweist, ein Signal oder Signale einer lokalen Zelle und/oder einer benachbarten Zelle oder benachbarter Zellen zu messen,
dass die Basisstation, die die Grundabdeckungszelle versorgt, eine zu aktivierende energiesparende Zelle bestimmt, wobei die Basisstation, die die Grundabdeckungszelle versorgt, eine zu aktivierende energiesparende Zelle gemäß einer lokalen Energiesparstrategie und einem Versorgungsbedarf des UE bestimmt, und
dass die Basisstation, die die Grundabdeckungszelle versorgt, die bestimmte energiesparende Zelle aktiviert.

2. Verfahren nach Anspruch 1, wobei die Basisstation, die die Grundabdeckungszelle versorgt, die energiesparende Zelle über eine S1- und/oder eine X2-Schnittstelle anweist, in den Zustand mit eingeschränkter Übertragung versetzt zu werden, und/oder
die Basisstation, die die Grundabdeckungszelle versorgt, die bestimmte energiesparende Zelle über eine S1- und/oder eine X2-Schnittstelle aktiviert.

3. Basisstation, umfassend:
ein Bestimmungsmodul (801), das dafür konfiguriert ist, eine erforderliche Aktivierung einer energiesparenden Zelle gemäß einem aktuellen Lastzustand der Basisstation, die eine Grundabdeckungszelle versorgt, zu bestimmen, wobei die Grundabdeckungszelle eine Zelle bezeichnet, die mit Blick auf garantierte Kontinuität nicht deaktiviert oder in einen energiesparenden Zustand versetzt werden kann, und die energiesparende Zelle eine Zelle bezeichnet, die in den energiesparenden Zustand versetzt werden kann,
**dadurch gekennzeichnet, dass** ein Anweisungsmodul (802) dafür konfiguriert ist, energiesparende Zellen anzuweisen, in einen Zustand mit eingeschränkter Übertragung versetzt zu werden, wobei das Anweisungsmodul (802) ferner dafür konfiguriert ist, die energiesparenden Zellen anzuweisen, in den Zustand mit eingeschränkter Übertragung versetzt zu werden, in dem nur eingeschränkter Abwärtsstreckensignale in den energiesparenden Zellen ohne Zugriffsbetrieb übertragen werden,
ein Anweisungsmodul (803), das dafür konfiguriert ist, ein Benutzerendgerät anzuweisen, ein Signal oder Signale einer lokalen Zelle und/oder einer benachbarten Zelle oder benachbarter Zellen zu messen,
ein Modul zur Bestimmung einer energiesparenden Zelle (804), das dafür konfiguriert ist, eine zu aktivierende energiesparende Zelle zu bestimmen, wobei das Modul zur Bestimmung einer energiesparenden Zelle (804) ferner dafür konfiguriert ist, eine zu aktivierende energiesparende Zelle gemäß einer lokalen Energiesparstrategie der Basisstation und einem Versorgungsbedarf des UE zu bestimmen, und
ein Aktivierungsmodul (805), das dafür konfiguriert ist, die bestimmte energiesparende Zelle zu aktivieren.

4. Basisstation nach Anspruch 3, wobei das Anweisungsmodul (802) ferner dafür konfiguriert ist, die energiesparende Zelle über eine S1- und/oder eine X2-Schnittstelle anzuweisen, in den Zustand mit eingeschränkter Übertragung versetzt zu werden, und/oder
das Anweisungsmodul (805) ferner dafür konfiguriert ist, die bestimmte energiesparende Zelle über eine S1- und/oder eine X2-Schnittstelle zu aktivieren.

## Revendications

1. Procédé pour un processus de commande d'une cellule d'économie d'énergie, comprenant :
une station de base desservant une cellule de couverture essentielle déterminant une activation requise d'une cellule d'économie d'énergie selon un état de charge en cours, dans lequel la cellule de couverture essentielle fait référence à une cellule qui ne peut pas être désactivée ou amenée dans un état d'économie d'énergie compte tenu d'une continuité garantie, et la cellule d'économie d'énergie fait référence à une cellule qui peut être amenée dans l'état d'économie d'énergie ;
**caractérisé en ce que**, la station de base desservant la cellule de couverture essentielle donne instruction à des cellules d'économie d'énergie d'être amenées dans un état de transmission limitée, dans lequel l'état de transmission limitée fait référence à la transmission de signaux de liaison descendante limités uniquement, sans aucune opération d'accès ;
la station de base desservant la cellule de couverture essentielle donne instruction à un équipement d'utilisateur de mesurer un signal ou des signaux d'une cellule locale et/ou d'une ou plusieurs cellules adjacentes ;
la station de base desservant la cellule de couverture essentielle détermine une cellule d'économie d'énergie à activer, dans lequel la station de base desservant la cellule de couverture essentielle détermine une cellule d'économie d'énergie à activer selon une stratégie d'économie d'énergie locale et une demande de service de l'équipement UE ; et
la station de base desservant la cellule de couverture essentielle active la cellule d'économie d'énergie déterminée.

2. Procédé selon la revendication 1, dans lequel la station de base desservant la cellule de couverture essentielle donne instruction aux cellules d'économie d'énergie d'être amenées dans l'état de transmission limitée par l'intermédiaire d'une interface S1 et/ou X2 ; et/ou
la station de base desservant la cellule de couverture essentielle active la cellule d'économie d'énergie déterminée par l'intermédiaire d'une interface S1 et/ou X2.

3. Station de base, comprenant :
un module de détermination (801) configuré de manière à déterminer une activation requise d'une cellule d'économie d'énergie selon un état de charge en cours de la station de base desservant une cellule de couverture essentielle, dans laquelle la cellule de couverture essentielle fait référence à une cellule qui ne peut pas être désactivée ou amenée dans un état d'économie d'énergie compte tenu d'une continuité garantie, et la cellule d'économie d'énergie fait référence à une cellule qui peut être amenée dans l'état d'économie d'énergie ;
**caractérisée par** un module d'instruction (802) configuré de manière à donner instruction à des cellules d'économie d'énergie d'être amenées dans un état de transmission limitée, dans laquelle le module d'instruction (802) est en outre configuré de manière à donner instruction aux cellules d'économie d'énergie d'être amenées dans l'état de transmission limitée, dans lequel seuls des signaux de liaison descendante limités sont transmis dans les cellules d'économie d'énergie, sans aucune opération d'accès ;
un module d'instruction (803) configuré de manière à donner instruction à un équipement d'utilisateur de mesurer un signal ou des signaux d'une cellule locale et/ou d'une ou plusieurs cellules adjacentes ;
un module de détermination de cellule d'économie d'énergie (804) configuré de manière à déterminer une cellule d'économie d'énergie à activer, dans lequel le module de détermination de cellule d'économie d'énergie (804) est en outre configuré de manière à déterminer une cellule d'économie d'énergie à activer selon une stratégie d'économie d'énergie locale de la station de base desservant la cellule de couverture essentielle et une demande de service de l'équipement UE ; et
un module d'activation (805) configuré de manière à activer la cellule d'économie d'énergie déterminée.

4. Station de base selon la revendication 3, dans laquelle le module d'instruction (802) est en outre configuré de manière à donner instruction aux cellules d'économie d'énergie d'être amenées dans l'état de transmission limitée par l'intermédiaire d'une interface S1 et/ou X2 ; et/ou
le module d'activation (805) est en outre configuré de manière à activer la cellule d'économie d'énergie déterminée, par l'intermédiaire d'une interface S1 et/ou X2.
